# FASCICULE DE BREVET EUROPEEN

(11) **EP 4 374 416 B1**
(45) Date de publication et mention de la délivrance du brevet: **06.08.2025**
(21) Numéro de dépôt: 22744803.2
(22) Date de dépôt: 28.06.2022
(51) Int. Cl.: H10K 30/30, H10K 85/50, H10K 30/50

(54) **COMPOSITION DE PRÉCURSEUR D'UNE PÉROVSKITE**
PEROWSKITVORLÄUFERZUSAMMENSETZUNG
PEROVSKITE PRECURSOR COMPOSITION

(30) Priorité: 23.07.2021 FR 2107987
(43) Date de publication de la demande: 29.05.2024
(73) Titulaire: PARIS SCIENCES ET LETTRES, 75006 Paris (FR); Ecole Nationale Superieure de Chimie de Paris, 75005 Paris (FR); Centre National de la Recherche Scientifique, 75016 Paris (FR)
(72) Inventeur: PAUPORTÉ, Thierry, 94300 VINCENNES (FR); ZHU, Tao, 75005 PARIS (FR)
(74) Mandataire: Novagraaf Technologies
(86) Numéro de dépôt international: PCT/FR2022/051277
(87) Numéro de publication internationale: WO 2023/002103

(56) Documents cités:
- CN-A- 113 078 267
- US-A1- 2020 090 876
- MIRHOSSEINI M ET AL: "Development of a triple-cation Ruddlesden-Popper perovskite structure with various morphologies for solar cell applications", JOURNAL OF MATERIALS SCIENCE: MATERIALS IN ELECTRONICS, CHAPMAN AND HALL, LONDON, GB, vol. 31, no. 4, 7 January 2020 (2020-01-07), pages 2766 - 2776, XP037005599, ISSN: 0957-4522, [retrieved on 20200107], DOI: 10.1007/S10854-019-02816-6

## Description

### Domaine technique

La présente invention se rapporte au domaine des pérovskites. Plus particulièrement, l'invention concerne une composition de précurseurs d'une pérovskite halogénée pour la fabrication d'une couche continue de pérovskite halogénée de basse dimension et de très grande stabilité destinée à être utilisée dans un dispositif photosensible et/ou optoélectronique.

Par pérovskite à basse dimension, au sens de la présente invention, on entend une pérovskite constituée de feuillets de plusieurs couches hybrides organique/inorganique qui sont superposées. Par exemple, comme pérovskite à basse dimension, on peut citer les pérovskites pseudo 2D.

Par grande stabilité, au sens de la présente invention, on entend une pérovskite qui résiste à des agents agressifs extérieurs comme l'humidité et l'oxygène.

### Art antérieur

La pérovskite désigne à l'origine le minéral CaTiO₃ (titanate de calcium). De nombreux oxydes de formule ABO₃ adoptent une structure de type pérovskite. Des pérovskites hybrides organique-inorganique ABX₃ ont été développées pour être appliquées à des dispositifs photosensibles, photovoltaïques notamment. Celles-ci peuvent être déposées en couches minces à partir de compositions de précurseurs de pérovskites halogénées. La température de cristallisation des couches de précurseurs de pérovskites halogénées est relativement faible (<160°C) et il est possible de moduler leur énergie de bande interdite en jouant sur la composition de précurseur. Leur mobilité de charges est élevée. Cependant, les pérovskites halogénées classiques obtenues sont peu stables ce qui entrave leur développement à l'échelle industrielle.

Pour augmenter la stabilité, la pérovskite ABX₃ peut être déposée dans une matrice mésoporeuse qui peut notamment être comprise dans des cellules photovoltaïques et qui peut, par exemple, être une triple couche mésoporeuses à base de TiO₂/ZrO₂/carbone ^{[1]}. Cependant, les rendements photovoltaïques de ce type de cellules photovoltaïques sont faibles (<15%).

Une autre solution consiste à éliminer les composés les plus nuisibles de la composition de précurseur de la pérovskite pour améliorer la stabilité de la couche de pérovskite issue de la composition de précurseur. Par exemple, des solutions actuellement proposées consistent à diminuer, voire éliminer, la composante organique généralement comprise dans les compositions de précurseurs des pérovskites, notamment le méthylammonium, voire le formamidinium. Cependant la simple élimination de ces composés ne suffit pas à garantir la stabilité de la couche de pérovskite obtenue, et notamment sa stabilité à l'humidité qui reste problématique. Il est également à noter qu'il est aujourd'hui difficile d'éliminer complétement la composante organique des compositions de précurseur de pérovskites et la remplacer par un cation élémentaire car aucun cation élémentaire n'est suffisamment gros (Cs⁺= 167 pm, Rb⁺= 152 pm, K⁺= 133 pm) pour ce remplacement (méthylammonium : 217 pm, formamidinium : + 253 pm).

Toujours pour augmenter la stabilité, une autre solution consiste à réduire la dimension de la pérovskite pour obtenir des couches de pérovskites de plus basse dimension. Cette réduction est rendue possible par ajout dans la composition de précurseur de pérovskite d'un autre composé organique de plus grande taille que ceux déjà présents dans la composition. Actuellement, comme autre composé organique de plus grande taille, on connait des composés thiol pour renforcer les interactions entre des feuillets inorganiques constituant une partie au moins de la couche de pérovskite obtenue, ou encore des composés fluorés pour augmenter la robustesse des matériaux pérovskites obtenus. MIRHOSSEINI M ET AL: JOURNAL OF MATERIALS SCIENCE: MATERIALS IN ELECTRONICS, vol. 31, no. 4, 7 janvier 2020, pages 2766-2776 divulgue une composition de précurseur d'une pérovskite quasi bidimensionnelle (2D) à trois cations: (S₁₋ₓS'ₓ)₂[Cs_{0.05}(FA₁₋ₓ MAₓ)_{0.95}]₃Pb₄(I₁₋ₓBrₓ)₁₃ dans laquelle - S est l'acide valérique 5-ammonium, S' est le bromure de tétra-n-octylammonium. US 2020/090876 A1 divulgue une pérovskite: FA_{(n-1-nw +w)}MA_{(wn-w)}PEA₂PDₙI_{(3n-3zn+3z-4e+1})Br(_{3zn-3z})SCN₄ₑ dans laquelle PEA est le phényléthylammonium.

Cependant, avec les couches de pérovskites à basse dimension, il est nécessaire d'obtenir une pérovskite présentant une phase homogène. De plus, les couches de pérovskite doivent être homogènes en composition ce qui est problématique avec les méthodes de fabrication actuellement mises en œuvre.

### Description de l'invention

Un des buts de l'invention est de remédier aux insuffisances des compositions et procédés de fabrication des couches de pérovskite de l'état de la technique.

Selon un premier aspect, l'invention concerne une composition de précurseur d'une pérovskite de la formule (I) suivante :

(A')₂FAₙ₋₁MA_{(n-1)y}Pbₙ₍₁₊ₓ₎Iₙ₍₃₊₂ₓ₎₊₁Cl_{y(n-1)} (I)

dans laquelle
A' est un composé organique d'ammonium, de préférence choisi parmi le benzylammonium, le phényléthylammonium, le n-propylammonium, le phenylammonium, l'histammonium, le cyclopentylammonium, le cyclohexylammonium, le cyclohexylmethylammonium, l'acide 4-butyrique d'ammonium, l'acide valérique 5-ammonium, ou encore l'isobutylammonium,
FA est le formamidinium,
MA est le méthylammonium,
n est compris entre 3 et 9,
x est compris entre 0,1 et 0,25,
y est compris entre 0,2 et 0,6,
la composition de précurseur comprenant :
de l'iodure de plomb à une proportion stœchiométrique de n(1+x) dans la composition de précurseur,
de l'iodure du composé organique d'ammonium à une proportion stœchiométrique de 2 dans la composition de précurseur,
de l'iodure de formamidinium à une proportion stœchiométrique de n-1 dans la composition de précurseur, et
un solvant aprotique polaire,
la composition étant caractérisée en ce que la composition comprend en outre du chlorure de méthylammonium à une concentration molaire comprise entre 20 et 60 % par rapport à la concentration molaire d'iodure de formamidinium dans la composition de précurseur, et en ce que la concentration molaire en iodure de plomb est comprise entre 0.6 et 1.5 mol/L. Selon ce premier aspect, l'invention permet, d'une part, de mettre en œuvre une composition homogène de précurseur d'une pérovskite, qui soit non stœchiométrique caractérisée par
une présence Pbl₂ en excès, et qui soit adaptée à la fabrication d'une couche de pérovskite, et d'autre part, de fabriquer des pérovskites halogénées de basse dimension, ce qui permet *in fine* d'améliorer la stabilité de la couche de pérovskite obtenue du fait de la présence d'un autre cation apporté par le composé organique d'ammonium A' qui permet l'obtention de rendement élevé pour ce type de composition.

Une telle composition permet le contrôle préalable, lors de la formation de la couche de pérovskite, de la cristallisation. Une telle composition permet de contrôler la dimensionnalité et de réduire la dispersion en n de la pérovskite obtenue après application de cette composition. Ainsi, on améliore la stabilité de la couche de pérovskite obtenue.

Il peut être avantageux d'utiliser des solvants aprotiques polaires spécifiques pour préparer des solutions dans laquelle les précurseurs sont dissous de manière optimale. Par conséquent, le solvant aprotique polaire peut être choisi parmi le N,N-diméthylformamide, le N-méthyl-2-pyrrolidone, le dichlorométhane, le tétrahydrofurane, l'acétate d'éthyle, l'acétonitrile, le diméthylsulfoxyde, l'acétone, le triamide hexaméthylphosphorique, la gamma-butyrolactone ou est un mélange des solvants aprotiques polaires précités.

De préférence, le solvant aprotique polaire est un mélange de solvants comprenant du N,N-diméthylformamide et du diméthylsulfoxyde. De préférence, dans ce mélange de solvants, la proportion volumique de N,N-diméthylformamide dans le mélange de solvants total peut être comprise entre 75% et 90% et la proportion volumique de diméthylsulfoxyde dans le mélange de solvants total peut être comprise entre 10% et 25%.

Il peut être avantageux d'obtenir une pérovskite présentant à la fois des performances et une stabilité suffisantes pour être utilisée dans les dispositifs photosensibles et/ou optoélectroniques. Par conséquent, n peut être compris de préférence entre 5 et 7. On peut par exemple ainsi obtenir des dispositifs présentant des rendements de conversion photovoltaïque environ égaux à 17,3%.

Corrélativement, l'invention vise aussi un procédé d'élaboration de la composition telle que décrite ci-avant, le procédé comprenant les étapes suivantes :
a) préparation d'une première solution d'une pérovskite de la formule (II) (A')₂FAₙ₋₁PbₙI₃ₙ₊₁, ladite préparation étant réalisée par mise en contact d'au moins de l'iodure du composé organique d'ammonium, de l'iodure de formamidinium et de l'iodure de plomb, le composé organique d'ammonium étant de préférence choisi parmi le benzylammonium, le phényléthylammonium, le n-propylammonium, le phenylammonium, l'histammonium, le cyclopentylammonium, le cyclohexylammonium, le cyclohexylmethylammonium, l'acide 4-butyrique d'ammonium, l'acide valérique 5-ammonium, ou encore l'isobutylammonium,
   la première solution étant caractérisée en ce que la stœchiométrie de chaque composé est la suivante:
   la proportion stœchiométrique de l'iodure du composé organique d'ammonium dans la composition est de 2,
   la proportion stœchiométrique d'iodure de formamidinium dans la composition est de n-1,
   la proportion stœchiométrique d'iodure de plomb dans la composition est de n,
   avec n étant compris entre 3 et 9,
b) préparation d'une deuxième solution par mise en contact au moins des composés ci-dessous :
   - de l'iodure de plomb présent dans la deuxième solution selon un rapport molaire par rapport à l'iodure de plomb dans la première solution compris entre 10% et 25%,
   - du chlorure de méthylammonium présent dans la deuxième solution selon un rapport molaire par rapport à l'iodure de formamidinium dans la première solution compris entre 20% et 60%,
c) formation d'une troisième solution dans laquelle la concentration molaire d'iodure de plomb est comprise entre 0.6 mol/L et 1.5 mol/L par mélange de ladite première solution et de ladite deuxième solution avec au moins un solvant aprotique polaire.

En mettant en œuvre un tel procédé d'élaboration, on obtient une composition homogène. Par ailleurs, si la troisième solution présente une concentration molaire d'iodure de plomb supérieure à 1.5 mol/L, la couche de pérovskite obtenue à l'aide de la composition de précurseur présentera des inclusions d'impuretés et il en résultera une couche de pérovskite discontinue. Si la troisième solution présente une concentration molaire d'iodure de plomb inférieure à 0.6 mol/L, la couche de pérovskite obtenue à l'aide de la composition de précurseur sera trop fine et il en résultera un risque élevé d'obtenir une couche de pérovskite qui soit elle aussi discontinue.

Il est à noter que dans la première solution, la concentration molaire en iodure de plomb ([Pbl₂]) est égale à n et que dans la deuxième solution, la concentration molaire en iodure de plomb est [Pbl₂] comprise entre 10% et 25% par rapport à la concentration molaire de l'iodure de plomb dans la première solution. Ainsi, la concentration molaire en iodure de plomb dans la troisième solution est égale à n + nx, équivalent à n (1+x), avec x compris entre 0.1 et 0.25.

Il peut être avantageux de dissoudre tous les précurseurs solides contenus dans la troisième solution afin d'obtenir une couche de pérovskite qui soit homogène et qui présente une phase relativement pure. Par conséquent, le procédé peut comprendre en outre, après l'étape c) de mélange, une étape d) d'agitation de ladite troisième solution pendant une durée comprise entre 1 heures et 5 heures à température ambiante.

De préférence, l'étape d) d'agitation de la troisième solution peut être réalisée dans une atmosphère inerte.

Selon un deuxième aspect, l'invention concerne la fabrication d'une couche continue de pérovskite, le procédé comprenant les étapes suivantes :
- dépôt de la composition telle que définie précédemment sur un support pour obtenir une couche de précurseur de pérovskite ; et
- traitement thermique de recuit à une température comprise entre 80 et 250°C pendant 10 min à 2h de la couche de précurseur de pérovskite pour obtenir une couche continue de pérovskite.

Il est à noter que l'étape de dépôt peut être réalisée par un procédé par filière plate, par revêtement par centrifugation, par pulvérisation, ou encore par couchage à la lame, ou encore par toute technique utilisant un dispositif d'enduction par centrifugation, une matrice à fente, l'évaporation sous vide, l'impression par jet d'encre, la racle ou encore le dépôt par laser pulsé.

Il est également à noter que l'étape de traitement thermique de recuit permet de cristalliser la couche de précurseur afin d'obtenir une couche de pérovskite. Cette cristallisation est permise par la croissance des grains et également par l'évaporation des solvants et au moins d'une partie du chlorure de méthylammonium contenue dans la couche de précurseur. Ainsi, lors de la mise en œuvre de l'étape de traitement thermique de recuit, il y a élimination partielle voire quasi-totale de méthylammonium et du chlorure. La stœchiométrie de la pérovskite ainsi obtenue n'est donc pas celle de la composition de précurseur.

Selon un troisième aspect, l'invention concerne une couche continue de pérovskite obtenue par le procédé tel que défini précédemment.

Cette couche de pérovskite présente une phase homogène et est à basse dimension.

Il peut être avantageux d'utiliser particulièrement cette couche de pérovskite dans les domaines du photovoltaïque ou de l'électroluminescence. Par conséquent, la couche continue de pérovskite peut être une couche mince, c'est-à-dire une couche définie par une épaisseur inférieure à 1µm.

Selon un quatrième aspect, l'invention concerne une utilisation d'une composition telle que définie précédemment pour obtenir une couche continue de pérovskite.

Selon un cinquième aspect, l'invention concerne un dispositif photosensible et/ou optoélectronique comprenant au moins une couche continue de pérovskite telle que définie précédemment.

Par exemple, le dispositif photosensible et/ou optoélectronique peut être une cellule photovoltaïque, un photodétecteur ou une diode électroluminescente.

D'autres avantages et particularités de la présente invention résulteront de la description qui va suivre, faite en référence aux exemples suivants.et en référence aux figures en annexe dans lesquelles :

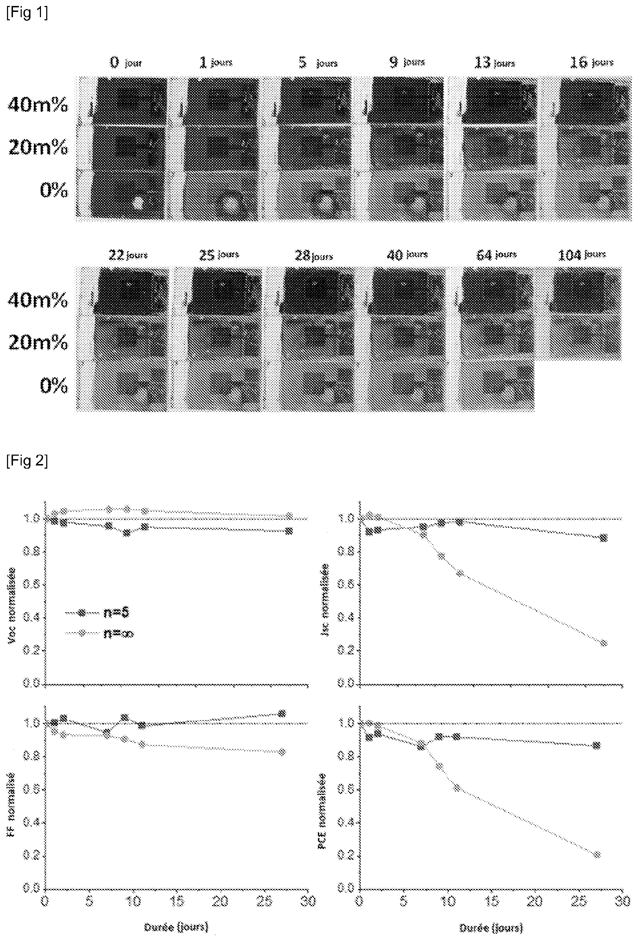

[Fig 1] la figure 1 représente des photographies mettant en avant l'évolution à l'air ambiant d'une cellule photovoltaïque comprenant deux couches de pérovskites (40m% et 20m%) issues d'une composition selon l'invention par rapport à une cellule photovoltaïque comprenant une couche de pérovskite (0%) obtenue par un procédé différent de celui de l'invention,
[Fig 2] la figure 2 représente des courbes représentant des caractéristiques courant-tension, après avoir été stockées en conditions ambiantes, d'une cellule photovoltaïque comprenant une couche de pérovskite issue d'une composition selon l'invention par rapport à une cellule photovoltaïque comprenant une couche de pérovskite obtenue par un procédé différent de celui de l'invention,

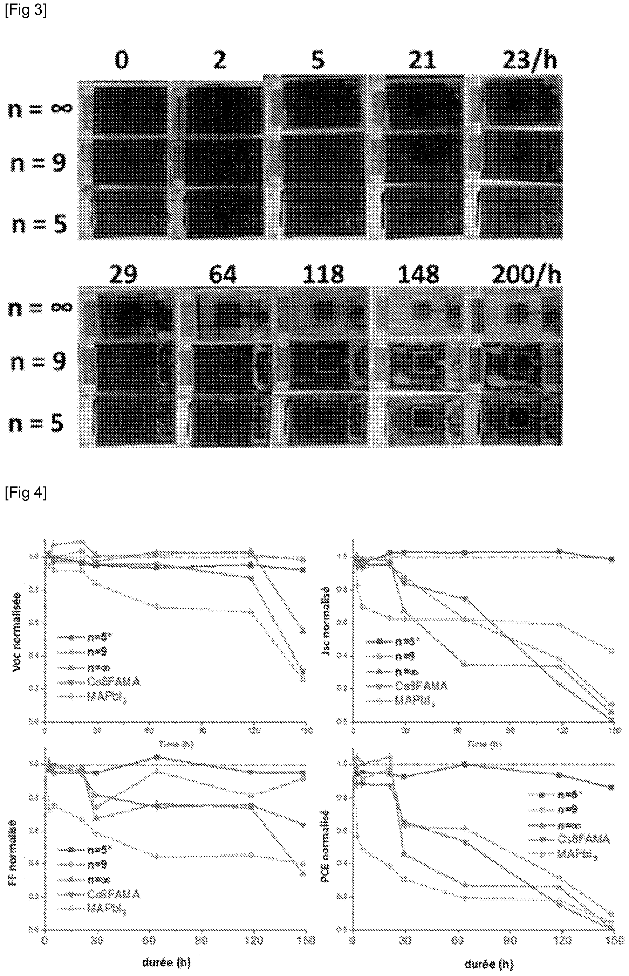

[Fig 3] la figure 3 représente des photographies mettant en avant l'évolution dans une atmosphère très humide (>90% RH), d'une cellule photovoltaïque comprenant une couche de pérovskite issue d'une composition selon l'invention par rapport à des cellules photovoltaïques comprenant une couche de pérovskite obtenue par un procédé différent de celui de l'invention,
[Fig 4] la figure 4 représente des courbes représentant des caractéristiques courant-tension, après avoir été stockées dans une atmosphère très humide (>90% RH), d'une cellule photovoltaïque comprenant une couche de pérovskite issue d'une composition selon l'invention par rapport à des cellules photovoltaïques comprenant une couche de pérovskite obtenue par un procédé différent de celui de l'invention,

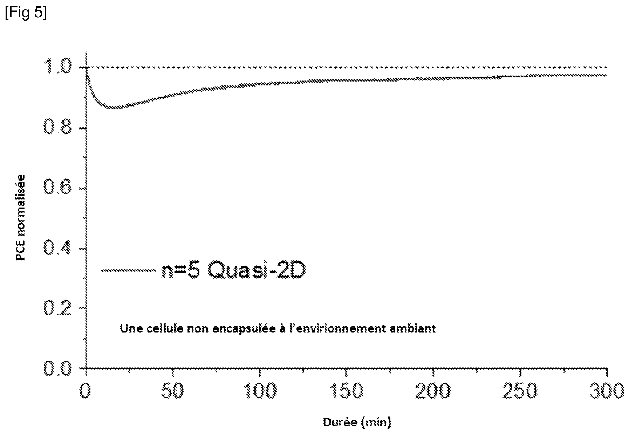

[Fig 5] la figure 5 représente une courbe représentant le rendement maximum d'une cellule photovoltaïque comprenant une couche de pérovskite issue d'une composition selon l'invention.

### Produits

iodure de formamidinium commercialisé par la société Greatcell Energy
iodure de plomb commercialisé par la société Tci Europe N.V.
iodure du composé organique d'ammonium :
   - hydroiodure de benzylamine (BEI) commercialisé par la société Tci Europe N.V. chlorure de méthylammonium commercialisé par la société Greatcell Energy solvants aprotiques polaires :
   - le N, N-diméthylformamide (DMF) commercialisé par la société Sigma Aldrich
   - le diméthylsulfoxyde (DMSO) commercialisé par la société Alfa Aesar

### Appareils

un dispositif de revêtement par centrifugation désigné par le nom commercial SPS POLOS SPIN150i, et commercialisé par la société S.P.S. bvba.

### Tests

Les performances des cellules photovoltaïques ont été obtenues à partir des courbes courant-potentiel mesurées sous un éclairement AM 1.5G 100 mW/cm⁻² émis à l'aide d'un appareil de simulation solaire Sun 2000 commercialisé par la société Abet Technologies.

La stabilité des cellules a été évaluée comme suit :
- en suivant la couleur et l'aspect des cellules photovoltaïques non encapsulées stockées à l'air ambiant pendant 104 jours ;
- en suivant les paramètres et le rendement photovoltaïques des cellules stockées à l'air ambiant pendant une durée de 28 jours ;
- en suivant la couleur et l'aspect des cellules photovoltaïques non encapsulées stockées dans une atmosphère très humide de 90% RH pendant 200 h ;
- en suivant les paramètres et le rendement photovoltaïques des cellules non encapsulées stockées dans une atmosphère très humide (>90% RH) pendant une durée de 150 h ;
- en suivant pendant 5 h, sous un éclairement AM 1.5G 100 mW/cm⁻², le rendement photovoltaïque de la cellule photovoltaïque comprenant une couche selon l'invention.

### Exemples

Des exemples de couches de pérovskite obtenues à l'aide de compositions de précurseurs fabriquées selon un mode de réalisation selon l'invention ou non ci-après indiqués ont été obtenues à partir de compositions de précurseurs dans lesquelles l'iodure de formamidinium, l'iodure de plomb, l'iodure du composé organique d'ammonium et le chlorure de méthylammonium ont été mélangés avec un mélange de solvants comprenant du N,N-diméthylformamide (DMF) (par exemple à une proportion volumique équivalente à 80 % par rapport au volume totale) et du diméthylsulfoxyde (DMSO) (par exemple à une proportion volumique équivalente à 20 % par rapport au volume totale).

En particulier, pour l'élaboration de ces compositions de précurseurs de pérovskite, on prépare une première solution et une deuxième solution que l'on mélange ensuite ensemble. La première solution est en particulier constituée d'hydroiodure de benzylamine (BEI), de l'iodure de formamidinium (FAI) et de l'iodure de plomb (PbI₂).

Dans la suite, seul le procédé permettant l'obtention de compo2 et compo3 et leur utilisation s'inscrivent dans le cadre de l'invention. Les procédés permettant l'obtention de compo1, compo4 et compo5 sont des exemples comparatifs non réalisée selon l'invention.

Des exemples de premières solutions premS1, premS2, premS3, premS4 et premS5 sont indiqués dans le tableau 1 suivant :

**[Tableau 1]**

| Désignation de la 1^{ère} solution | BEI *en mg* | FAI *en mg* | Pbl₂ *en mg* |
|---|---|---|---|
| premS1 | 50,92 | 74,51 | 236,49 |
| premS2 | 50,92 | 74,51 | 236,49 |
| premS3 | 50,92 | 74,51 | 236,49 |
| premS4 | 31,3 | 91,8 | 276,6 |
| premS5 | 0 | 103,18 | 276,6 |

Des exemples de deuxièmes solutions deuxS1, deux S2, deux S3, deux S4 et deuxS5 sont indiqués dans le tableau 2 suivant :

**[Tableau 2]**

| Désignation de la 2^{ème} solution | Pbl₂ *en mg* | MACI *en mg* |
|---|---|---|
| deuxS1 | 63,16 | 0 |
| deuxS2 | 63,16 | 5,85 |
| deuxS3 | 63,16 | 11,7 |
| deuxS4 | 0 | 12,98 |
| deuxS5 | 0 | 14,6 |

Ensuite, on met en contact :
- premS1 avec deuxS1 pour obtenir S1,
- premS2 avec deuxS2 pour obtenir S2,
- premS3 avec deuxS3 pour obtenir S3,
- premS4 avec deuxS4 pour obtenir S4, et
- premS5 avec deuxS5 pour obtenir S5.

Finalement, on mélange chacune des solutions obtenues S1, S2, S3, S4 et S5 avec un mélange de solvants constitué de 400µL de N,N-diméthylformamide (DMF) et 100 µL de diméthylsulfoxyde (DMSO) pour obtenir respectivement Compo1, Compo2, Compo3, Compo4 et Compo5 présentant les compositions indiquées dans le tableau 3 :

**[Tableau 3]**

| Désignation des compositions de précurseur | BEI *en mol*/*L* | FAI *en mol*/*L* | Pbl₂ *en mol*/*L* | MACI *en mol*/*L* | DMF/DMSO *en µL* |
|---|---|---|---|---|---|
| Compo1 | 0,432 mol/L | 0.866 mol/L | 1.3 mol/L | 0 mol/L | 500 µL |
| Compo2 | 0,432 mol/L | 0.866 mol/L | 1.3 mol/L | 0.172 mol/L | 500µL |
| Compo3 | 0.432 mol/L | 0.866 mol/L | 1.3 mol/L | 0.344 mol/L | 500µL |
| Compo4 | 0,2666 mol/L | 1,068 mol/L | 1,2 mol/L | 0,384 mol/L | 500µL |
| Compo5 | 0 mol/L | 1,2 mol/L | 1,2 mol/L | 0,432 mol/L | 500µL |

Compo2 et Compo3 sont des compositions obtenues selon l'invention et comprennent du chlorure de méthylammonium respectivement à une concentration molaire environ égale à 20 % et 40 % par rapport à la concentration molaire d'iodure de formamidinium.

Chacune des compositions Compo1, Compo2, Compo3, Compo4 et Compo5 sont ensuite agitées à température ambiante pendant 2h à 5h dans une boîte à gants sous N₂. Les autres étapes sont les mêmes que celles décrites dans le protocole ci-avant décrit.

En particulier, chacune pérovskites issues des compostions obtenues est définie par les formules suivantes :

**Compo 1** (n=5, x=0.2, y=0) : (A')₂FA₄MA₀Pb₆I₁₈Cl₀

(n dans la plage comprise entre 3 et 9, x dans la plage comprise entre 0,1 et 0,25 et y en dehors de la plage comprise entre 0,2 et 0,6).

**Compo 2** (n=5, x=0.2, y=0.2) : (A')₂FA₄MA_{0.8}Pb₆ I₁₈Cl_{0.8}

(n dans la plage comprise entre 3 et 9, x dans la plage comprise entre 0,1 et 0,25 et y dans la plage comprise entre 0,2 et 0,6).

**Compo 3** (n=5, x=0.2, y=0.4) : (A')₂FA₄MA_{1.6}Pb₆I₁₈Cl_{1.6}

(n dans la plage comprise entre 3 et 9, x dans la plage comprise entre 0,1 et 0,25 et y dans la plage comprise entre 0,2 et 0,6).

**Compo 4** (n=9, x= 0, y=0.36 ) : (A')₂FA₈MA_{2.88}Pb₉I₂₈Cl_{2.88}

(n dans la plage comprise entre 3 et 9, x en dehors de la plage comprise entre 0,1 et 0,25 et y dans la plage comprise entre 0,2 et 0,6).

**Compo 5** (n=∞, x= 0, y=0.36 ) : FAMA_{0.36}PbI₃Cl_{0.36}

(n en dehors de la plage entre 3 et 9, x en dehors de la plage comprise entre 0,1 et 0,25 et y dans la plage comprise entre 0,2 et 0,6).

### Réalisation de couches

Ensuite, toutes les couches de pérovskite selon les exemples de réalisation ont été fabriquées dans une boîte à air sec (RH≤10%).

Pour fabriquer chacune des couches des exemples ci-dessous, 50 µL de chacune des compostions de précurseur Compo1, Compo2, Compo3, Compo 4 et Compo5 telles que préparées a été saisi et a été appliqué sur un substrat constitué d'un ensemble comprenant d'une couche de verre, d'une couche d'oxyde d'étain dopé fluor (FTO) et d'une ou de deux couches de TiO₂.

Ensuite, chacun de ces substrats revêtus de Compo1, Compo2, Compo3, Compo4 ou Compo5 est déposé dans l'appareil de dépôt « *spin coater* » programmé de sorte à fonctionner à une vitesse environ égale à 1000 rpm pendant 10 s puis à une vitesse environ égale à 6000 rpm pendant 30s. Parallèlement aux dépôts de ces substrats revêtus, 100 µL de chlorobenzène a été éjecté sur chacune des couches Compo1, Compo2, Compo3, Compo4 ou Compo5 après 20 s à compter du démarrage du *« spin-coater ».* Cette étape permet de diminuer la solubilité des précurseurs en solution et de former une couche de précurseur qui donnera ensuite, lors du recuit, la pérovskite.

Après fonctionnement du *« spin-coater »,* chacun des substrats revêtus est placé sur une plaque chauffante, dont la température de consigne est environ égale à 153 °C (température de l'écran). La durée d'un tel traitement thermique de recuit est environ égale à 13 min. Après ce traitement thermique, on obtient des couches de pérovskites.

Les performances des couches de pérovskite issues des Compo1 (n= 5), Compo2 (n= 5), Compo3 (n= 5), Compo4 (n = 9) ou Compo5 (n = ∞) sont représentées dans le tableau 4 ci-après à l'aide de résultats de tests réalisés sur des cellules photovoltaïques comprenant, entre autres, chacune une de ces couches de pérovskite.

En particulier, chacune de ces cellules photovoltaïques est constituée de : verre/FTO/ couche compacte de TiO₂ (20 nm)/couche poreuse de TiO₂ (120 nm)/Perovskite (350 nm-420 nm)/Spiro-OMeTAD (200 nm)/Au (60 nm) :

**[Tableau 4]**

| Pérovskite dans la cellule photovoltaïques | Rendement de conversion photovoltaïque (%) |
|---|---|
| Compo1 | 13,01 |
| Compo2 | 14,14 |
| Compo3 | 17,32 |
| Compo4 | 17,68 |
| Compo5 | 20,84 |

### Tests de stabilité :

Comme indiqué dans la figure 1, la cellule photovoltaïque comprenant une couche de pérovskite issue de compo1 (0%, n = 5) ne conserve pas la couleur brun-noir sur la durée du test contrairement à la cellule photovoltaïque comprenant une couche de pérovskite issue de compo2 (20m%, n= 5) et compo3 (40m%, n = 5).

Des cellules photovoltaïques comprenant une couche issue de compo3 (n=5, selon l'invention) et compo5 ((n = ∞) correspondant à une pérovskite 3D) ont été stockées en conditions ambiantes et leurs caractéristiques courant-tension ont été mesurées sur 28 jours (voir figure 2).

Les cellules photovoltaïques comprenant une couche issue de compo3 (n=5, selon l'invention), compo4 (n = 9) et compo5 (n = ∞) ont été stockées dans une atmosphère très humide (>90% RH). Leur aspect a évolué comme la figure 3. On remarque que la cellule photovoltaïque comprenant une couche issue de compo3 conserve sa couleur noire en atmosphère très humide.

Et les performances photovoltaïques (paramètres des courbes courant-tension) de ces cellules photovoltaïques ont évoluées comme indiqué en figure 4.

MAPbl₃ et Cs₈FAMA sont deux pérovskites 3D. Celles-ci sont obtenues comme décrit dans l'article scientifique [4].

En particulier, pour la pérovskite MAPbl₃, on prépare une couche de MAPbl₃ en réalisant une solution de précurseur MAPI 1.45 M en mélangeant 668.5 mg de Pbl₂ et 230.5 mg de MAI dans 1mL de DMSO. La solution obtenue est ensuite agitée et maintenue à 100°C pendant 2h avant utilisation. Le programme de spincoating était de 1000 rpm pendant 10s et 6000 rpm pendant 30 s. Ensuite, 100 µL de chlorobenzène ont été injectée à 30s après le début de l'activation du spincoating. Enfin, les couches ont finalement été recuites sur une plaque chauffante à 105 °C pendant 60 minutes.

Concernant Cs₈FAMA, on prépare une solution de précurseur correspondant à une composition de couche de pérovskite Cs_{0.08}FA_{0.80}MA_{0.12}Pb(I_{0.88}Br_{0.12})₃. Tout d'abord, on mélange 179 mg d'iodure de formamidinium (FAI), 17,4 mg de bromure de méthylammonium (MABr), 27,0 mg de Csl, 548 mg de PbI₂ et 57,1 mg de PbBr₂ dans 220 µL de DMSO et 780 µL de DMF. Ensuite, on agite la solution obtenue pendant un minimum de 3-4 h à température ambiante dans une boîte à gants remplie de N₂. Puis, des échantillons de 29, 30, 31 et 45 µL de cette solution ont été placés sur le dessus de substrats. Un programme de spincoating en deux étapes a été employé : d'abord une rotation à 1000 rpm pendant 10 s, puis à 6000 rpm pendant 30 s. 100 µL de chlorobenzène ont été injecté 20 s après le début de l'activation du spincoating. Les films obtenus ont ensuite été recuits à 105 °C pendant 1 h dans une atmosphère sèche.

Après 150h, la cellule photovoltaïque comprenant une couche issue de compo3 ne perd que 15 % de ses performances initiales quand les autres cellules ont des rendements inférieurs à 15 %.

Le rendement maximum de la cellule photovoltaïque comprenant une couche issue de compo3 a été suivi pendant 5 h sous un éclairage de AM 1,5G 100 mW/cm² comme l'illustre la figure 5.

Toutes ces mesures montrent une stabilité très élevée des cellules photovoltaïques comprenant une couche de pérovskite selon l'invention.

### Liste des références

[1] Anyi Mei, Yusong Sheng, Yue Ming, Yue Hu, Yaoguang Rong, Weihua Zhang, Guangren Na, Chengbo Tian, Shuang Liu, Satoshi Uchida, Tae-Woong Kim, Yongbo Yuan, Lijun Zhang, Yinhua Zhou, Hongwei Han, « Stabilizing Perovskite Solar Cells to IEC61215:2016 Standards with over 9,000-h Operational Tracking », Joule, Volume 4, Issue 12, 16 Decembre 2020, Pages 2646-2660.
[2] Hui Ren, Shidong Yu, Lingfeng Chao, Yingdong Xia, Yuanhui Sun, Shouwei Zuo, Fan Li, Tingting Niu, Yingguo Yang, Huanxin Ju, Bixin Li, Haiyan Du, Xingyu Gao, Jing Zhang, Jianpu Wang, Lijun Zhang, Yonghua Chen, Wei Huang, « Efficient and stable Ruddlesden-Popper perovskite solar cell with tailored interlayer molecular interaction », nature photonics, Volume 14, 13 Janvier 2020, Pages 154-163.
[3] Sajjad Ahmad, Ping Fu, Shuwen Yu, Qing Yang, Xuan Liu, Xuchao Wang, Xiuli Wang, Xin Guo, Can Li, « Dion-Jacobson Phase 2D Layered Perovskites for Solar Cells with Ultrahigh Stability », Joule, Volume 3, Issue 3, 20 Marche 2019, Pages 794-806.
[4] Daming Zheng, Tao Zhu, Thierry Pauporté, « Using Mnovalent-to trivalent-Cation Hybrid Perovskites for Producing High-Efficiency Solar Cells : Electrical Response, Impedance, and Stability » ACS Appl. Energy Mater. 2020, 3, 10349-10361.

## Revendications

1. Composition de précurseur d'une pérovskite de la formule (I) suivante :
(A')₂FAₙ₋₁MA_{(n-1)y}Pbₙ₍₁₊ₓ₎Iₙ₍₃₊₂ₓ₎₊₁Cl_{y(n-1)} (I)
dans laquelle
- A' est un composé organique d'ammonium, de préférence choisi parmi le benzylammonium, le phényléthylammonium, le n-propylammonium, le phenylammonium, l'histammonium, le cyclopentylammonium, le cyclohexylammonium, le cyclohexylmethylammonium, l'acide 4-butyrique d'ammonium, l'acide valérique 5-ammonium, ou encore l'isobutylammonium,
- FA est le formamidinium,
- MA est le méthylammonium,
- n est compris entre 3 et 9,
- x est compris entre 0,1 et 0,25,
- y est compris entre 0,2 et 0,6,
ladite composition de précurseur comprenant :
- de l'iodure de plomb à une proportion stœchiométrique de n(1+x) dans la composition de précurseur,
- de l'iodure du composé organique d'ammonium à une proportion stœchiométrique de 2 dans la composition de précurseur,
- de l'iodure de formamidinium à une proportion stœchiométrique de n-1 dans la composition de précurseur, et
- un solvant aprotique polaire,
la composition étant **caractérisée en ce que** la composition comprend en outre du chlorure de méthylammonium à une concentration molaire comprise entre 20 et 60 % par rapport à la concentration molaire d'iodure de formamidinium dans la composition de précurseur, et **en ce que** la concentration molaire en iodure de plomb est comprise entre 0.6 et 1.5 mol/L.

2. Composition selon la revendication 1, selon laquelle ledit solvant aprotique polaire est choisi parmi le N,N-diméthylformamide, le N-méthyl-2-pyrrolidone, le dichlorométhane, le tétrahydrofurane, l'acétate d'éthyle, l'acétonitrile, le diméthylsulfoxyde, l'acétone, le triamide hexaméthylphosphorique, la gamma-butyrolactone ou est un mélange des solvants aprotiques polaires précités.

3. Composition selon l'une des revendications 1 ou 2, selon laquelle n est compris entre 5 et 7.

4. Procédé d'élaboration de la composition selon l'une quelconque des revendications 1 à 3, ledit procédé comprenant les étapes suivantes :
a) préparation d'une première solution d'une pérovskite de la formule (II) (A')₂FAₙ₋₁PbₙI₃ₙ₊₁, ladite préparation étant réalisée par mise en contact d'au moins de l'iodure d'un composé organique d'ammonium, de l'iodure de formamidinium et de l'iodure de plomb, le composé organique d'ammonium étant de préférence choisi parmi le benzylammonium, le phényléthylammonium, le n-propylammonium, le phenylammonium, l'histammonium, le cyclopentylammonium, le cyclohexylammonium, le cyclohexylmethylammonium, l'acide 4-butyrique d'ammonium, l'acide valérique 5-ammonium, ou encore l'isobutylammonium,
la première solution étant **caractérisée en ce que** la stœchiométrie de chaque composé est la suivante:
- la proportion stœchiométrique de l'iodure du composé organique d'ammonium dans la composition est de 2,
- la proportion stœchiométrique d'iodure de formamidinium dans la composition est de n-1,
- la proportion stœchiométrique d'iodure de plomb dans la composition est de n,
avec n étant compris entre 3 et 9,
b) préparation d'une deuxième solution par mise en contact au moins des composés ci-dessous :
- de l'iodure de plomb présent dans la deuxième solution selon un rapport molaire par rapport à l'iodure de plomb dans la première solution compris entre 10% et 25%,
- du chlorure de méthylammonium présent dans la deuxième solution selon un rapport molaire par rapport à l'iodure de formamidinium dans la première solution compris entre 20% et 60%,
c) formation d'une troisième solution dans laquelle la concentration molaire d'iodure de plomb est comprise entre 0.6 mol/L et 1.5 mol/L par mélange de ladite première solution et de ladite deuxième solution avec au moins un solvant aprotique polaire.

5. Procédé selon la revendication 4, comprenant en outre, après l'étape c) de mélange, une étape d) d'agitation de ladite troisième solution pendant une durée comprise entre 1 heures et 5 heures à température ambiante.

6. Procédé de fabrication d'une couche continue de pérovskite, le procédé comprenant les étapes suivantes :
- dépôt de la composition telle que définie selon l'une des revendications 1 à 3 sur un support pour obtenir une couche de précurseur de pérovskite ; et
- traitement thermique de recuit à une température comprise entre 80 et 250°C pendant 10 min à 2h de la couche de précurseur de pérovskite pour obtenir une couche continue de pérovskite.

7. Utilisation d'une composition selon l'une des revendications 1 à 3 pour obtenir une couche continue de pérovskite.

8. Dispositif photosensible et/ou optoélectronique comprenant au moins une couche continue de pérovskite obtenue selon la revendication 6.

## Patentansprüche

1. Vorläuferzusammensetzung eines Perovskits der folgenden Formel (I) :
(A')₂FAₙ₋₁MA_{((n-1))(y)}Pb₍ₙ₎₍₁₊ₓ₎In₍₃₊₂ₓ₎₊₁Cl _{(y(n-1))} (I)
in der
- A' eine organische Ammoniumverbindung ist, vorzugsweise ausgewählt aus Benzylammonium, Phenylethylammonium, n-Propylammonium, Phenylammonium, Histammonium, Cyclopentylammonium, Cyclohexylammonium, Cyclohexylmethylammonium, Ammonium-4-Buttersäure, 5-Ammoniumvaleriansäure oder Isobutylammonium,
- FA ist Formamidinium,
- MA ist Methylammonium,
- n liegt zwischen 3 und 9,
- x liegt zwischen 0,1 und 0,25,
- y zwischen 0,2 und 0,6 liegt,
wobei die Vorläuferzusammensetzung umfasst:
- Bleiiodid in einem stöchiometrischen Verhältnis von n(1+x) in der Vorläuferzusammensetzung,
- lodids der organischen Ammoniumverbindung in einem stöchiometrischen Verhältnis von 2 in der Vorläuferzusammensetzung,
- Formamidiniumiodid in einem stöchiometrischen Verhältnis von n-1 in der Vorläuferzusammensetzung und
- ein polares aprotisches Lösungsmittel,
wobei die Zusammensetzung **dadurch gekennzeichnet ist, dass** die Zusammensetzung ferner Methylammoniumchlorid in einer molaren Konzentration zwischen 20 und 60 %, bezogen auf die molare Konzentration von Formamidiniumiodid in der Vorläuferzusammensetzung, umfasst, und
dass die molare Konzentration von Bleiiodid zwischen 0,6 und 1,5 mol/L liegt.

2. Zusammensetzung nach Anspruch 1, wobei das polare aprotische Lösungsmittel ausgewählt ist aus N,N-Dimethylformamid, N-Methyl-2-pyrrolidon, Dichlormethan, Tetrahydrofuran, Ethylacetat, Acetonitril, Dimethylsulfoxid, Aceton, Hexamethylphosphortriamid, gamma-Butyrolacton oder eine Mischung der vorstehend genannten polaren aprotischen Lösungsmittel ist.

3. Zusammensetzung nach einem der Ansprüche 1 oder 2, wobei n zwischen 5 und 7 liegt.

4. Verfahren zur Herstellung der Zusammensetzung nach einem der Ansprüche 1 bis 3, wobei das Verfahren die folgenden Schritte umfasst:
a) Herstellung einer ersten Lösung eines Perowskits der Formel (II) (A')₂FAₙ₋₁PbₙI₃ₙ₊₁, wobei die Herstellung durch In-Kontakt-Bringen von mindestens einem lodid einer organischen Ammoniumverbindung, Formamidiniumiodid und Bleiiodid erfolgt, wobei die organische Ammoniumverbindung vorzugsweise aus Benzylammonium, Phenylethylammonium, n-Propylammonium, Phenylammonium, Histammonium, Cyclopentylammonium, Cyclohexylammonium, Cyclohexylmethylammonium, Ammonium-4-Buttersäure, Valeriansäure-5-Ammonium oder Isobutylammonium ausgewählt ist,
wobei die erste Lösung **dadurch gekennzeichnet ist, dass** die Stöchiometrie jeder Verbindung wie folgt ist:
- der stöchiometrische Anteil des Iodids der organischen Ammoniumverbindung in der Zusammensetzung beträgt 2,
- der stöchiometrische Anteil von Formamidiniumiodid in der Zusammensetzung beträgt n-1,
- der stöchiometrische Anteil von Bleiiodid in der Zusammensetzung beträgt n,
wobei n zwischen 3 und 9 liegt,
b) Herstellung einer zweiten Lösung durch In-Kontakt-Bringen mindestens den folgenden Verbindungen:
- des in der zweiten Lösung vorhandenen Bleiiodids in einem Molverhältnis zum Bleiiodid in der ersten Lösung zwischen 10 % und 25 %,
- Methylammoniumchlorid, das in der zweiten Lösung in einem Molverhältnis zu Formamidiniumiodid der ersten Lösung zwischen 20 % und 60 % vorliegt,
c) Bildung einer dritten Lösung, in der die molare Konzentration von Bleiiodid zwischen 0,6 mol/L und 1,5 mol/L liegt, durch Mischen der ersten Lösung und der zweiten Lösung mit mindestens einem polaren aprotischen Lösungsmittel.

5. Verfahren nach Anspruch 4, das nach dem Schritt c) des Mischens zusätzlich einen Schritt d) des Rührens der dritten Lösung über eine Dauer von 1 bis 5 Stunden bei Raumtemperatur umfasst.

6. Verfahren zur Herstellung einer kontinuierlichen Schicht aus Perowskit, wobei das Verfahren die folgenden Schritte umfasst:
- Abscheidung der Zusammensetzung, wie sie in einem der Ansprüche 1 bis 3 definiert ist, auf einem Träger, um eine Schicht eines Perowskit-Vorläufers zu erhalten; und
- Wärmebehandlung durch Glühen der Perowskit-Vorläuferschicht bei einer Temperatur zwischen 80 und 250°C einen Zeitraum von 10 Minuten bis 2 Stunden, um eine kontinuierliche Perowskit-Schicht zu erhalten.

7. Verwendung einer Zusammensetzung nach einem der Ansprüche 1 bis 3, zur Herstellung einer kontinuierlichen Perowskit-Schicht.

8. Lichtempfindliche und/oder optoelektronische Vorrichtung mit mindestens einer kontinuierlichen Perowskit-Schicht, die gemäß Anspruch 6 hergestellt wurde.

## Claims

1. A perovskite precursor composition according to the following formula (I):
(A')₂FAₙ₋₁MA_{(n-1)y}Pbₙ₍₁₊ₓ₎Iₙ₍₃₊₂ₓ₎₊₁Cl _{y(n-1)} (I)
in which
- A' is an organic ammonium compound, preferably selected from benzylammonium, phenylethylammonium, n-propylammonium, phenylammonium, histammonium, cyclopentylammonium, cyclohexylammonium, cyclohexylmethylammonium, 4-ammonium butyric acid, 5-ammonium valeric acid, or isobutylammonium,
- FA is formamidinium,
- MA is methylammonium,
- n is between 3 and 9,
- x is between 0.1 and 0.25,
- y is between 0.2 and 0.6,
said precursor composition comprising:
- lead iodide at a stoichiometric proportion of n(1+x) in the precursor composition,
- iodide of the organic ammonium compound at a stoichiometric proportion of 2 in the precursor composition,
- formamidinium iodide at a stoichiometric proportion of n-1 in the precursor composition, and
- a polar aprotic solvent,
the composition being **characterized in that** the composition further comprises methyl ammonium chloride at a molar concentration of between 20 and 60% relative to the molar concentration of formamidinium iodide in the precursor composition, and
**in that** the molar concentration of lead iodide is between 0.6 and 1.5 mol/L.

2. The composition according to claim 1, wherein said polar aprotic solvent is selected from N,N-dimethylformamide, N-methyl-2-pyrrolidone, dichloromethane, tetrahydrofuran, ethyl acetate, acetonitrile, dimethyl sulfoxide, acetone, hexamethylphosphorous triamide, gamma-butyrolactone, or is a mixture of the aforementioned polar aprotic solvents.

3. The composition according to one of claims 1 or 2, wherein n is between 5 and 7.

4. A method for producing the composition according to any one of claims 1 to 3, said method comprising the following steps:
a) preparing a first solution of a perovskite of formula (II) (A')₂FAₙ₋₁PbₙI₃ₙ₊₁, said preparation being carried out by bring into contact at least the iodide of an organic ammonium compound, formamidinium iodide and lead iodide, the organic ammonium compound preferably being selected from benzyl ammonium, phenethylammonium, n-propylammonium, phenylammonium, histammonium, cyclopentylammonium, cyclohexylammonium, cyclohexylmethylammonium, 4-ammonium butyric acid, 5-ammonium valeric acid, or isobutyl ammonium,
the first solution being **characterized in that** the stoichiometry of each compound is as follows:
- the stoichiometric proportion of the iodide of the organic ammonium compound in the composition is 2,
- the stoichiometric proportion of formamidinium iodide in the composition is n-1,
- the stoichiometric proportion of lead iodide in the composition is n, with n being between 3 and 9,
b) preparing a second solution by bringing at least the compounds below into contact:
- lead iodide present in the second solution at a molar ratio relative to lead iodide in the first solution of between 10% and 25%,
- methyl ammonium chloride present in the second solution at a molar ratio relative to formamidinium iodide in the first solution of between 20% and 60%,
c) forming a third solution wherein the molar concentration of lead iodide is between 0.6 mol/L and 1.5 mol/L by mixing said first solution and said second solution with at least one polar aprotic solvent.

5. The method according to claim 4, further comprising, after step c) of mixing, a step d) of stirring said third solution for a period of between 1 hour and 5 hours at room temperature.

6. The method for manufacturing a continuous layer of perovskite, the method comprising the following steps:
- depositing the composition as defined according to one of claims 1 to 3 on a support to obtain a perovskite precursor layer; and
- annealing heat treatment at a temperature between 80 and 250°C for 10 min at 2 hours of the perovskite precursor layer to obtain a continuous layer of perovskite.

7. The use of a composition according to one of claims 1 to 3 to obtain a continuous layer of perovskite.

8. A photosensitive and/or optoelectronic device comprising at least one continuous layer of perovskite obtained according to claim 6.
